# EUROPEAN PATENT APPLICATION

(11) **EP 2 620 967 A1**
(43) Date of publication of application: **31.07.2013**
(21) Application number: 13152632.9
(22) Date of filing: 25.01.2013
(51) Int. Cl.: H01H 9/04, H01H 11/00

(54) **Connection structure of housing of electronic apparatus and connection method of forming housing**

(30) Priority: 25.01.2012 JP 2012012912
(71) Applicant: OMRON CORPORATION, Kyoto-shi, Kyoto 600-8530 (JP)
(72) Inventor: Kobayashi, Minoru, Kyoto, 600-8530 (JP)
(74) Representative: Lahrtz, Fritz

(57) **Abstract**

A connection structure of a housing of an electronic apparatus and a connection method of forming a housing, both of which are able to secure a desired strength by integrally combining even end surfaces of an opening edge portion of a thin-wall housing into one piece with ultrasonic welding is disclosed herein. The connection structure of the housing of the electronic apparatus is formed by matching end surfaces of opening edge portions of a first case and a second case and integrally combining the end surfaces into one piece in a welding manner. Particularly, a welding protrusion rim protruding along an end surface of an opening edge portion of the second case is melted to be welded on a welding fitting groove, on which a crimp process is performed along an end surface of an opening edge portion of the first case, for integration into one piece.

## Description

### BACKGROUND OF THE INVENTION

### 1. TECHNICAL FIELD

The present invention relates to a connection structure of a housing of an electronic apparatus, and particularly to a connection structure of a housing which is integrally formed in one piece through ultrasonic welding and a connection method of forming a housing.

### 2. RELATED ART

In the related art, for example, as illustrated in Fig. 4 in Japanese Unexamined Patent Publication No. 2000-268663, as a connection structure of a housing of an electronic apparatus, there is a connection structure of an encapsulated-typed small-sized switch, which is integrally formed by fitting a housing 7 into a base 10 and then performing ultrasonic welding.

However, with the connection structure described above, there is a problem that its application is difficult to find and a desired strength is hard to obtain, in a case where end surfaces of an opening edge portion of a thin-wall housing are welded with ultrasonic welding.

### SUMMARY

The present invention has been devised to solve the problems described above, and an object thereof is to provide a connection structure of a housing of an electronic apparatus and a connection method of forming a housing, both of which are able to secure a desired strength by connecting end surfaces of an opening edge portion into one piece with ultrasonic welding even in the case of a thin-wall housing.

In accordance with one aspect of the present invention, there is provided a connection structure of a housing of an electronic apparatus formed by matching end surfaces of opening edge portions of a first case and a second case that make up the housing, said structure comprising:
a welding protrusion rim protruding along the end surface of the second case;
a welding surface formed along the opening edge portion of the first case;
   wherein the end surface of the first case is configured by means of a crimp process to enable it to integrally combine the welding protrusion rim and the welding surface into one piece in a welding manner.

According to the present invention, because a surface area of the welding surface increases through a crimp process, an area where the welding surface and the melted welding protrusion rim come into contact with each other increases, and thus a strength of the weld increases.

As the embodiment of the present invention, a protrusion may be provided along at least an inside edge portion in the welding surface formed along the end surface of the opening edge portion of the first case.

According to the embodiment, the melted welding protrusion is prevented from flowing at least inward, and thus a defect due to the inward flowing of the melted welding protrusion rim may be avoided.

As another embodiment of the present invention, a welding fitting groove may be formed by providing a protrusion rim along each of both edge portions in the welding surface formed along the end surface of the opening edge portion of the first case.

According to the present embodiment, the melted welding protrusion rim is prevented from flowing inward and outward, and thus the obtained housing has a good appearance and is produced with a good yield.

As another embodiment of the present invention, a thickness dimension of the first case and the second may be 2mm or less. According to the present embodiment, an application may be found in a thin-wall housing, and the housing with a wide range of applications is obtained.

As still another embodiment of the present invention, a cross-sectional area of the welding fitting groove may be greater than a cross-sectional area of the welding protrusion rim.

According to the present embodiment, the melted welding protrusion rim is prevented from overflowing the welding fitting groove, and thus the housing has a good appearance and is produced with a good yield.

As yet another embodiment of the present invention, the welding protrusion rim may have a triangle-shaped cross section.

According to the present embodiment, because a top portion of the welding protrusion rim with the triangle-shaped cross section is easy to melt and work efficiency is increased in a case where the ultrasonic welding is performed, the connection structure of the housing of the electronic apparatus with high productivity is obtained.

In accordance with another aspect of the present invention, there is provided a connection method of forming a housing of an electronic apparatus, the method including matching end surfaces of opening edge portions of a first case and a second case that make up the housing with each other, and melting a welding protrusion rim to be welded on a welding surface of a welding fitting groove to integrally combine the welding protrusion rim and the welding surface in one piece, by performing ultrasonic welding while causing the welding protrusion rim protruding along the end surface of the opening edge portion of the second case to come into contact with the welding fitting groove having the welding surface, on which a crimp process is performed along the end surface of the opening edge portion of the first case.

According to the present invention, because a surface area of the welding surface increases through a crimp process, an area where the welding surface and the melted welding protrusion rim come into contact with each other increases, and thus a welding strength increases.

As an embodiment of the present invention, a cross-sectional area of the welding fitting groove may be greater than the cross-sectional area of the welding protrusion rim.

According to the present embodiment, the melted welding protrusion rim is prevented from overflowing the welding fitting groove, and thus the housing has a good appearance and is produced with a good yield.

As another embodiment of the present invention, the welding protrusion rim may have a triangle-shaped cross-section.

According to the present embodiment, because the top portion of the welding protrusion rim with the triangle-shaped cross-section is easy to melt and work efficiency is increased in a case where the ultrasonic welding is performed, there is an effect that the connection method of forming the housing of the electronic apparatus with high productivity is obtained.

### BRIEF DESCRIPTION OF THE DRAWINGS

Fig. 1A is a perspective view illustrating a trigger switch to which a connection structure of a housing of an electronic apparatus according to the present invention is applied and Fig. 1B is a perspective view illustrating the housing thereof;
Fig. 2 is an expanded perspective view illustrating one case, a first case, of the housing illustrated in Figs. 1A and 1B;
Fig. 3 is an enlarged perspective view illustrating the other case, a second case, of the housing illustrated in Figs. 1A and 1B;
Fig. 4A is a front view illustrating the housing illustrated in Figs. 1A and 1B and Fig. 4B is a cross-sectional view taken along line BB of Fig. 4A; and
Fig. 5A is a partially enlarged view of Fig. 4B, and Figs. 5B and 5C are partially enlarged views to describe a connection method, subsequent to Fig. 5A.

### DETAILED DESCRIPTION

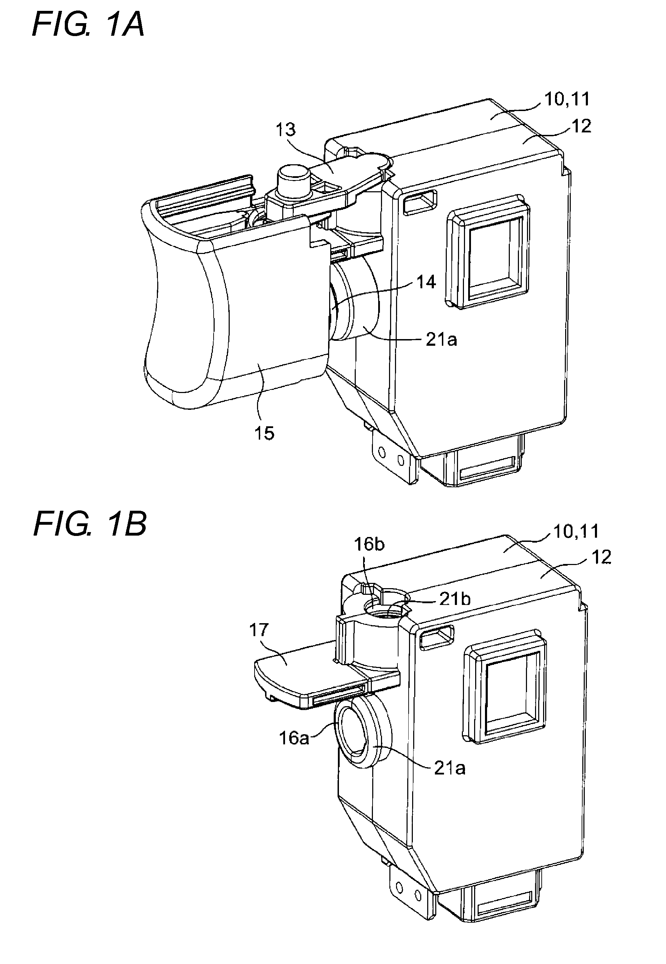

An embodiment is described referring to Figs. 1A to 5C, in which a connection structure according to the present invention is applied to a trigger switch.

In the trigger switch according to the present embodiment, a drive mechanism unit and a contact mechanism unit, which are not illustrated in the drawing, are built into a housing 10 that is formed by integrally combining first and second cases 11 and 12 into one piece in a welding manner with ultrasonic welding. In addition, the trigger switch may operate, for example, the drive mechanism unit by changing an operation direction with a position-regulating cam member 13 and pulling a trigger 15 inward via a bellow-shaped packing 14.

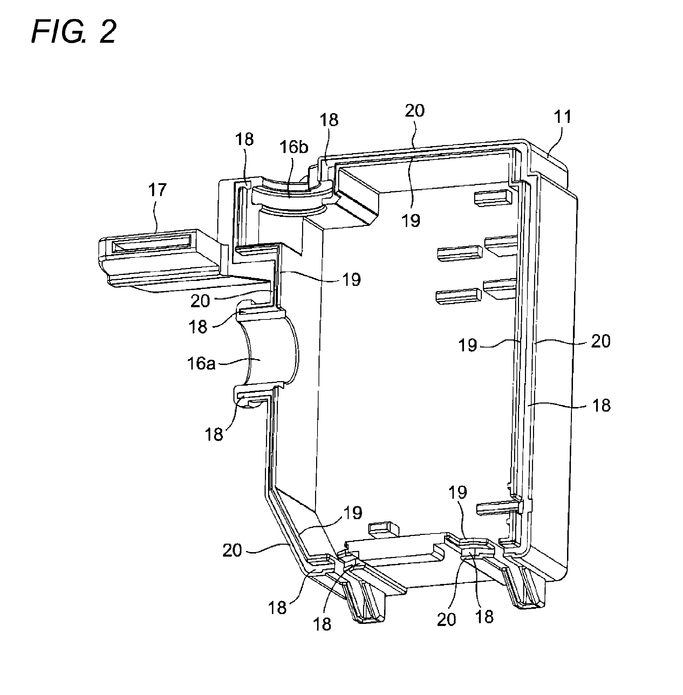

As illustrated in Fig. 2, the first case 11 making up the housing 10 is in the form of a box that has a substantially U-shaped cross section. A protrusion portion 16a with a semi-cylindrical shaped cross-section to support the trigger 15 is provided in the center of the lateral surface of the first case 11 in such a manner as to protrude, and a shaft-inserted semicircular hole 16b to support a rotating shaft portion (not illustrated) of the position-regulating cam member 13 is provided in the upper surface edge portion of the first case 11. Moreover, in the first case 11, a plate-shaped rib 17 to support the trigger 15 is provided in the vicinity of the protrusion portion 16a in such a manner as to protrude.

In addition, a welding fitting groove 18 is provided along an opening edge portion of the first case 11.

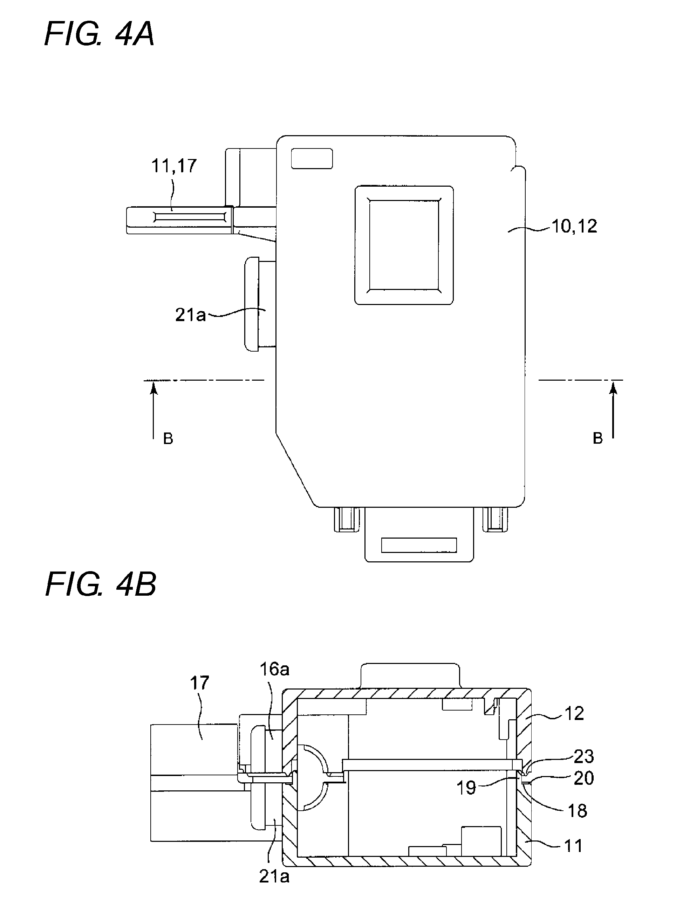

In the welding fitting groove 18, protrusion rims 19 and 20 (Figs. 4A and 4B) are provided in parallel with both lateral edge portions thereof, in such a manner as to protrude, and in order to increase a welding strength, a crimp process is performed on a welding surface, which is the bottom surface of the welding fitting groove 18, and thus the welding surface is made to be a satin finished surface. More specifically, the surface roughness Rz of the bottom ranges from 10 µm to 50 µm, and preferably, from 15 µm to 25 µm. When the surface roughness Rz is in the range of less than 10 µm, the welding strength may not have a predetermined shock resistance strength, and when the surface roughness Rz is in the range of more than 50 µm, a problem occurs in terms of uniform welding and sealing performance. In addition, at this point, the surface roughness Rz means an average value of ten units in unevenness between a valley and a peak that are adjacent to each other.

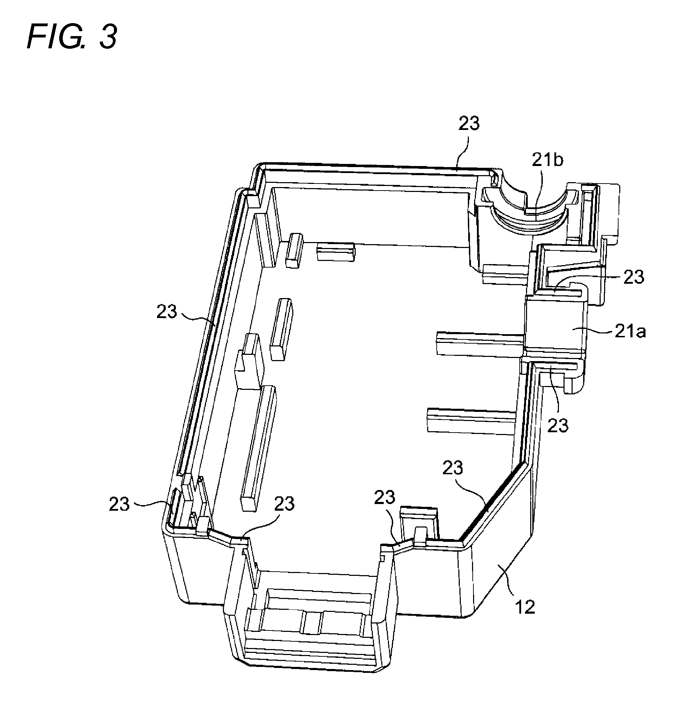

The second case 12, as illustrated in Fig. 3, is in the form of a box that has a substantially U-shaped cross section and that has a plane shape to make the matching with the first case 11 possible. A protrusion portion 21a with a semi-cylindrical shaped cross-section to support the trigger 15 is provided in the center of the lateral surface of the second case 12 in such a manner as to protrude, and a shaft-inserted semicircular hole 21b to support the rotating shaft portion (not illustrated) of the position-regulating cam member 13 is provided in the upper surface edge portion of the second case 12. Moreover, a welding protrusion rim 23 with a triangle-shaped cross-section that may fit into the welding fitting groove 18 is provided along the opening edge portion of the second case 12. The welding protrusion rim 23 is not limited to the triangle-shaped cross-section, and for example, may have a semi-elliptical shaped cross-section.

In addition, the thickness of each of the matching portions of the first and second cases 11 and 12 ranges from 1.0 mm to 2.0 mm and preferably, from 1.2 mm to 1.5 mm. The sufficient welding strength may be secured even though the thickness is in the range of 2.0 mm or less, but when the thickness is in the range of less than 1.0 mm, the area where the crimp process is performed is small, and as a result the sufficient welding strength may not be obtained.

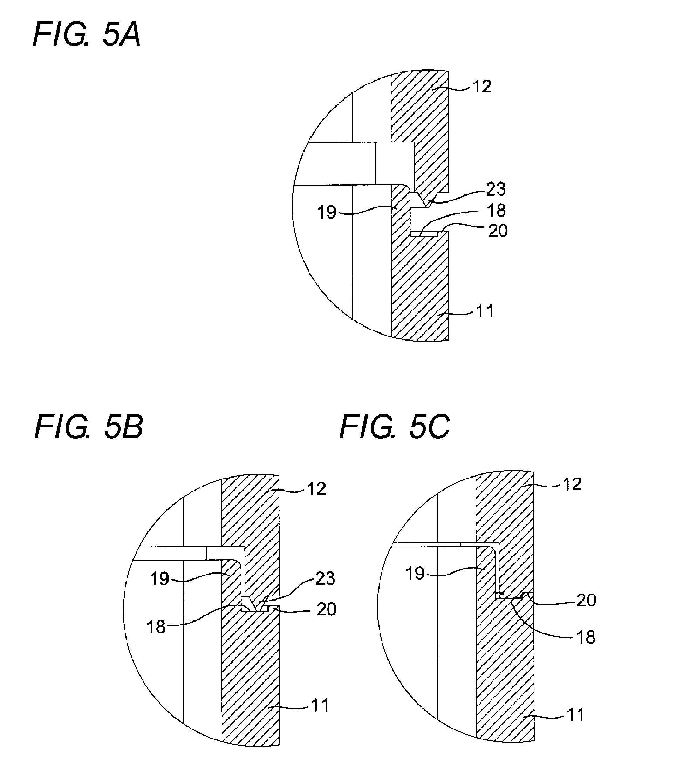

Next, a method of assembling the trigger switch is described. First, internal constituent parts making up the drive mechanism unit and the contact mechanism unit that are not illustrated in the drawing are installed into the first case 11 and the bellow-shaped packing 14, the trigger 15, and the position-regulating cam member 13 are installed. Next, the second case 12 is put on the first case 11, and as illustrated in Fig. 5A, the welding protrusion rim 23 is made to approach the welding fitting groove 18. Subsequently, as illustrated in Fig. 5B, the ultrasonic welding is performed, while making the welding protrusion rim 23 come into contact with the welding fitting groove 18. Accordingly, the welding protrusion rim 23 is melted to be welded on the welding fitting groove 18 for integration into one piece and thus the first case 11 and the second case 12 are integrally combined into one piece.

In addition, a welding-used integration method is not limited to the ultrasonic welding, and there are no limitations as long as the welding-used integration method is a method by which the welding protrusion rim 23 may be melted to be welded and thus integrally combined with the welding fitting groove 18.

According to the present embodiment, the protrusion rims 19 and 20 protruding from both of the edge portions of the welding fitting groove 18 prevent the melted resin material from flowing outward, and thus there is an advantage that the trigger switch with a good appearance may be obtained with a good yield.

### Example 1

A sample of the trigger switch was obtained by installing ordinary internal constituent parts in the first and second cases 11 and 12 with the matching portions each being 1.5 mm in thickness, as illustrated in Figs. 1A and 1B, and then integrally combining the first and second cases 11 and 12 into one piece with ultrasonic welding. A width dimension of the welding fitting groove 18 on which the crimp process was performed was 0.7 mm, and the averaged surface roughness Rz for 10 points on the bottom thereon was 17.7386 µm.

Then, the experiment was performed to check the first and second cases 11 and 12 for their dislocation state after letting the sample fall freely from a height of 200 cm to a structure made of concrete.

The free-fall experiment was performed 20 times with respect to each of 3 samples, but no sample, whose first and second cases 11 and 12 were separated from each other, was found among these samples.

It could be confirmed that the samples had the predetermined shock resistance performance, by determining whether or not the welding portion is dislocated in the free-fall experiments.

The connection structure of the electronic apparatus according to the present invention is not limited to the trigger switch, but may, of course, be applied to other electronic apparatuses, such as a limit switch and a relay.

There has thus been shown and described a connection structure of housing of electronic apparatus and connection method of forming housing which fulfills all the objects and advantages sought therefore. Many changes, modifications, variations and other uses and applications of the subject invention will, however, become apparent to those skilled in the art after considering this specification and the accompanying drawings which disclose the preferred embodiments thereof. All such changes, modifications, variations and other uses and applications which do not depart from the spirit and scope of the invention are deemed to be covered by the invention, which is to be limited only by the claims which follow.

Although the invention has been described in detail for the purpose of illustration based on what is currently considered to be the most practical and preferred embodiments, it is to be understood that such detail is solely for that purpose and that the invention is not limited to the disclosed embodiments, but, on the contrary, is intended to cover modifications and equivalent arrangements that are within the spirit and scope of the appended claims. For example, it is to be understood that the present invention contemplates that, to the extent possible, one or more features of any embodiment can be combined with one or more features of any other embodiment.

## Claims

1. A connection structure of a housing of an electronic apparatus formed by matching end surfaces of opening edge portions of a first case and a second case that make up the housing, said structure comprising:
a welding protrusion rim protruding along the end surface of the second case;
a welding surface formed along the opening edge portion of the first case;
wherein the end surface of the first case is configured by means of a crimp process to enable it to integrally combine the welding protrusion rim and the welding surface into one piece in a welding manner.

2. The connection structure of the housing of the electronic apparatus according to claim 1, wherein a protrusion is provided along at least an inside edge portion in the welding surface.

3. The connection structure of the housing of the electronic apparatus according to claim 2, wherein a welding fitting groove is formed along the opening edge portion of the first case.

4. The connection structure of the housing of the electronic apparatus according to claim 1, wherein a thickness dimension of the first and the second case is 2 mm or less.

5. The connection structure of the housing of the electronic apparatus according to claim 2, wherein a thickness dimension of the first and the second case is 2 mm or less.

6. The connection structure of the housing of the electronic apparatus according to claim 3, wherein a thickness dimension of the first and the second case is 2 mm or less.

7. The connection structure of the housing of the electronic apparatus according to claim 3, wherein a cross-sectional area of the welding fitting groove is greater than a cross-sectional area of the welding protrusion rim.

8. The connection structure of the housing of the electronic apparatus according to claim 6, wherein a cross-sectional area of the welding fitting groove is greater than a cross-sectional area of the welding protrusion rim.

9. The connection structure of the housing of the electronic apparatus according to claim 1, wherein the welding protrusion rim has a triangle-shaped cross-section.

10. The connection structure of the housing of the electronic apparatus according to any one of claims 5 to 8, wherein the welding protrusion rim has a triangle-shaped cross-section.

11. A connection method of forming a housing of an electronic apparatus, the method comprising:
matching end surfaces of opening edge portions of a first case and a second case that make up the housing, with each other; and
melting a welding protrusion rim to be welded on a welding surface of a welding fitting groove to integrally combine the welding protrusion rim and the welding surface into one piece, by performing ultrasonic welding while causing the welding protrusion rim protruding along the end surface of the opening edge portion of the second case to come into contact with the welding fitting groove having the welding surface, on which a crimp process is performed along the end surface of the opening edge portion of the first case.

12. The connection method of forming a housing of an electronic apparatus according to claim 11, wherein a cross-sectional area of the welding fitting groove is greater than a cross-sectional area of the welding protrusion rim.

13. The connection method of forming a housing of an electronic apparatus according to claim 11 or 12, wherein the welding protrusion rim has a triangle-shaped cross-section.
